# EUROPÄISCHE PATENTSCHRIFT

(11) **EP 3 346 544 B1**
(45) Veröffentlichungstag und Bekanntmachung des Hinweises auf die Patenterteilung: **24.02.2021**
(21) Anmeldenummer: 18150167.7
(22) Anmeldetag: 03.01.2018
(51) Int. Cl.: H01Q 1/22, H01Q 15/02

(54) **WAVER LEVEL PACKAGE MIT INTEGRIERTER ODER EINGEBETTETER ANTENNE**
WAVER LEVEL PACKAGE TYPE WITH INTEGRATED OR EMBEDDED ANTENNA
ENCAPUSLATION SUR TRANCHE COMPORTANT UNE ANTENNE INTÉGRÉE OU INCORPORÉE

(30) Priorität: 05.01.2017 DE 102017200124
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: Ndip, Ivan, 13469 Berlin (DE); BRAUN, Tanja, 14052 Berlin (DE)
(74) Vertreter: Pfitzner, Hannes

(56) Entgegenhaltungen:
- EP-A1- 3 065 220
- DE-A1-102006 023 123
- US-A1- 2008 029 886

## Beschreibung

Ausführungsbeispiele der vorliegenden Erfindung beziehen sich auf ein Wafer Level Package mit integrierter Antenne sowie ein Herstellungsverfahren. Weitere Ausführungsbeispiele beziehen sich auf ein Wafer Level Package mit integriertem Antennenelement sowie entsprechendes Herstellungsverfahren. Bevorzugte Ausführungsbeispiele beziehen sich auf eine Fan-Out-Panel-/Wafer Level-basierte System-Integrationsplattform mit integrierter Antenne oder in einem Moldmaterial eingebettete Antenne.

Um dem steigenden Bedarf an mehr Bandbreite, höherer Datenrate, kleinerer Latenz und größerer Datensicherheit nachzukommen, werden für die Entwicklung drahtloser Systeme Chips mit höheren Betriebsfrequenzen (z. B. in Mikrowellen und Millimeterwellen Frequenzbereiche) eingesetzt. Aber je höher die Frequenz, desto größer ist die Dämpfung der Übertragungsstrecke. Um diese Dämpfung zu überwinden, müssen die drahtlosen Systeme über Antennen mit hoher Effizienz und Gewinn verfügen. Antennen sind die wesentlichen Elemente von Drahtlossystemen.

In drahtlosen Systemen sind Antennen entweder im Chip, auf dem Interposer oder auf der Leiterplatte (System-Board) integriert. Chip-integrierte Antennen können zu einer höheren Systemminiaturisierung und Kostenreduktion führen, weil sie zusammen mit dem Chip gleichzeitig hergestellt werden können. Außerdem ist die elektrische Verbindung zwischen einem Front-End Chip und einer Antenne sehr kurz. Solche Antennen haben jedoch eine sehr geringe Effizienz und Gewinn, was auf die höhere Permitivität von Chipmaterial (z.B. Silizium) sowie der Substrat- und Metallisierungsverluste der Chiptechnologien zurückzuführen ist. Deshalb sind sie für die Entwicklung künftiger Hochfrequenzsystemen ungeeignet. Antennen, die entweder auf dem Interposer oder auf der Leiterplatte integriert sind, können eine viel höhere Effizienz und Gewinn haben, solange die Antennen mit Hochfrequenzsubstraten hergestellt sind.

Der Signalpfad zwischen einem Front-end Chip und einer auf einem Interposer oder einer Leiterplatte integrierten Antenne ist aber lang und besteht aus vielen geometrischen Diskontinuitäten (z. B. Chipverbindungen wie Drahtbonds, Leitungen mit Knicken, Durchkontaktierungen usw.). Dieser Pfad verursacht Signalintegritätsprobleme wie Reflektion, Dämpfung, Signalverzögerung, Übersprechen und auch unerwünschte Strahlung, welche die gesamte Systemleistung verschlechtern.

Um diese Probleme zu vermeiden, müssen die Antennen ganz dicht zum Front-end Chips integriert werden. Dafür sind Systemintegrationsplattformen, die eine solche Integration ermöglichen, unabdingbar.

Im Stand der Technik gibt es einige Ansätze, wie die Systemintegration bewerkstelligt wurde. Fan-Out-Wafer Level Package (FO-WLP) basierte Systemintegrationsplattformen haben das Potenzial solche Integration zu gewährleisten. Beim FOWLP werden keine Interposer verwendet, hier kann die Integration von Antennen auf demselben Substrat, in dem die Chips eingebettet sind, erfolgen. Dadurch wird der Signalpfad zwischen den Chips und der Antenne reduziert und die Signalintegritätsprobleme vermindert.

Die US 2008/0029886 A1 beschreibt ein Silizium-basiertes Package mit einem integrierten Antennenelement.

Die DE 10 2006 023 123 A1 beschreibt ein Halbleitermodul mit integriertem Antennenelement.

Die drei führenden Beispiele von FO-WLP-basierten Systemintegrationsplattformen sind:
- Embedded Wafer Level Ball Grid Array (eWLB) von Infineon [1]
- Redistributed Chip Package (RCP) von Freescale [2]
- Integrated Fan-Out WLP (InFO-WLP) von TSMC [3]

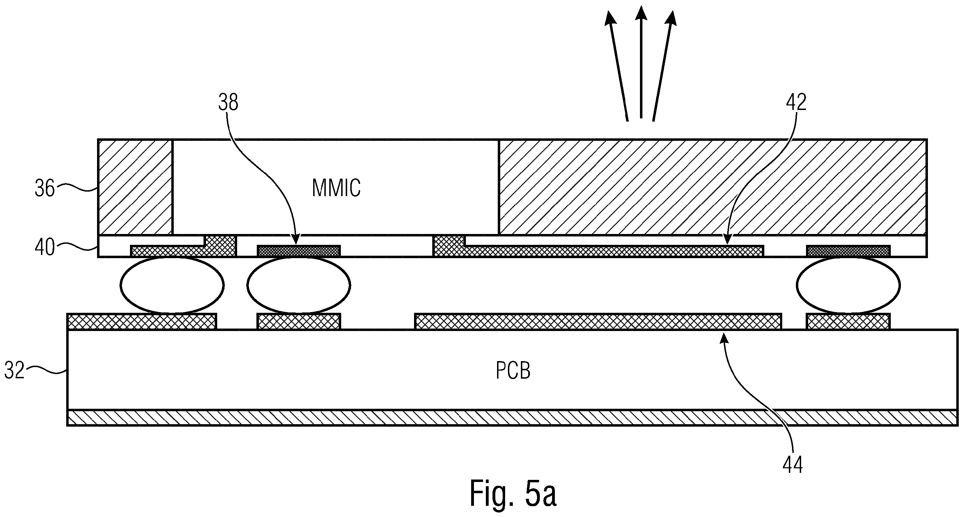

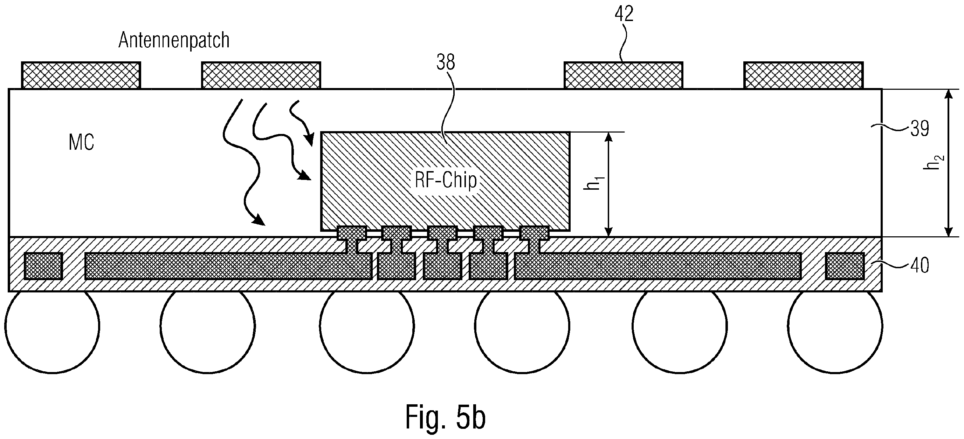

Bisher wurden eWLB und InFO-WLP für drahtlose Systeme eingesetzt und demonstriert. Die Figs. 5a und 5b stellen eWLB und InFO-WLP mit integrierten Antennen dar.

Fig. 5a zeigt eine Kombination aus PCB 32 mit eWLB 36, das einen Chip (z. B. RF-Chip) 38 sowie eine in der Umverdrahtungsschicht 40 des eWLB 36 angeordnete Antenne 42 umfasst. Zur Verbesserung der Signalabstrahlcharakteristik ist gegenüber von der Antenne 42 auf dem PCB Board 32 ein Reflektor 44 vorgesehen.

Fig. 5b zeigt eine InFO-WLB-Integration. Hier ist der Chip 38 in ein Gussharz 39 eingebettet, wobei auf der Unterseite des Chips die Umverdrahtungsschicht 40 vorgesehen ist. Auf der gegenüberliegenden Seite zu der Umverdrahtungsschicht 40 sind Antennenelemente 42 angeordnet.

In eWLB wird das strahlende Element der Antenne auf der Umverdrahtungslage (engl. Redistribution Layer - RDL) und der Reflektor auf der Leiterplatte integriert. Dadurch hängt die Funktionalität der Antennen und auch der Plattform von den Abmessungen der Packagekontaktierung z. B. BGA Balls und deren Prozessschwankungen sowie von der Leiterplattentechnologie ab. Dadurch kann die FOWLP Systemintegrationsplattform nur in Verbindungen mit den Kontakten/BGA Balls, der Leiterplatten Technologien und der Underfill Materialen optimiert werden.

Die Antennen in eWLB und InFO können nicht optimiert werden, ohne die Abmessungen der RDL und des Moldmaterials anzupassen, was die Designfreiheit der Plattform begrenzt.

Sowohl in eWLB als auch in InFO sind die Felder der integrierten Antennen nicht von den Chips und anderen integrierten Komponenten geschirmt. Die unerwünschte Wechselwirkung kann zu EMV Problemen führen.

In eWLB kann die Strahlung einer integrierten Antenne nicht die ganze Halbkugel (die gesamte horizontale und vertikale Schicht) abdecken, ohne unerwünschte Kopplung mit anderen integrierten Komponenten zu verursachen. Der Grund dafür ist, dass andere Komponenten auf derselben Schicht wie die Antennen integriert sind. Deshalb besteht der Bedarf nach einem verbesserten Ansatz.

Aufgabe der vorliegenden Erfindung ist es, ein Konzept zu schaffen, mittels welchem eine Antenne in einem Wafer Level Package (Wafer basierten Gehäuse) integriert werden kann, das insgesamt einen verbesserten Kompromiss aus höherer Designfreiheit, geringerer elektromagnetischer Beeinflussung zwischen elektrischen Bauelementen und Antenne sowie Übertragungseffizienz darstellt.

Die Aufgabe wird durch den Gegenstand der unabhängigen Patentansprüche gelöst.

Ausführungsbeispiele eines Aspekts der vorliegenden Erfindung schaffen ein Wafer Level Package mit integrierter Antenne. Das Wafer Level Package umfasst eine Kontaktierungsschicht, eine Umverdrahtungsschicht mit der integrierten Antenne sowie eine zwischen der Kontaktierungsschicht und der Umverdrahtungsschicht angeordnete Chipschicht mit zumindest einem Chip. Die integrierte Antenne ist in der Antennenschicht derart angeordnet, dass ihre Projektionsfläche versetzt oder maximal teilweise überlappend mit der Projektionsfläche des zumindest einen Chips der Chipschicht ist. Die Kontaktierungsschicht umfasst für die Antenne einen Reflektor bzw. der Reflektor ist auf einer der Antenne abgewandten Seite angeordnet, um so mit selbiger wechselzuwirken. Um nun den Chip vor Beeinflussung der elektromagnetische Strahlung (RF) zu schützen, ist neben Chip bzw. zwischen Chip und Antenne ein (oder mehrere) sog. Schirm-Via angeordnet.

Das oder die Schirm-Vias sind entsprechend Ausführungsbeispielen im Bereich zwischen der Antenne und den Chips vorgesehen, d.h. in der Chipschicht, z. B. am Rande des Chips integriert. Zusätzlich können die Schirm-Vias als Schirm-Via-Reihe oder parallele Reihen vorkommen, um die Schirmung weiter zu verbessern.

Die integrierten Antennen können entsprechend weiteren Ausführungsbeispielen auch "intelligent", d. h. rekonfigurierbar, steuerbar, adaptiv bzw. smart ausgeführt sein. Die hierfür regelmäßig erforderliche Elektronik (z. B. Schaltungen und/oder Dioden) für die Rekonfigurierbarkeit kann in der Umverdrahtungsebene oder im Polymersubstrat mitintegriert sein. Hierbei wäre es auch entsprechend weiteren Ausführungsbeispielen denkbar, dass die Elektronik für die Steuerung der Antenne (z. B. Phasenschieber) entweder in der Umverdrahtungsebene oder im Polymersubstrat angeordnet ist.

Ausführungsbeispielen liegt die Erkenntnis zugrunde, dass es einerseits kosteneffizient ist bzw. allgemein den Herstellungsprozess verbessert, wenn die Antenne in der Umverdrahtungsschicht und der Reflektor in der gegenüberliegenden Kontaktierungsschicht angeordnet werden, wobei auch die Nachteile in Bezug auf die Abstrahlungseinbußen infolge von den Kontakten (zur Kontaktierung mit einem weiteren Element) dadurch reduziert werden können, dass zusätzlich zu der Umverdrahtungsschicht auf einer in Bezug auf den Chip gegenüberliegenden Seite eine Kontaktierungsschicht vorgesehen ist. Weiter kann entsprechend einem zusätzlichen, bevorzugten Ausführungsbeispiel auch eine gegenseitige Beeinflussung von Chip und Antenne minimiert werden, wenn das Antennenelement in der Umverdrahtungsschicht versetzt zu den Chips angeordnet ist und zwischen dem strahlenden Bereich und den Chips Schirmungs-Mittel, wie Vias vorgesehen werden.

Über Vias, die entsprechend weiteren Ausführungsbeispielen ebenfalls in der Chipschicht vorgesehen sein können, ist es möglich, dass die Umverdrahtungsschicht mit der Kontaktierungsschicht verbunden wird. Somit kann der Chip über die Kontaktierungsschicht und Umverdrahtungsschicht von außen kontaktiert werden. Zusätzlich wäre es auch denkbar, dass eine beidseitige Kontaktierung des Chips vorgesehen ist, so dass also der Chip auch auf der Seite der Kontaktierungsschicht kontaktierbar wäre. An dieser Stelle sei angemerkt, dass entsprechend Ausführungsbeispielen zwischen der Umverdrahtungsschicht und der Chipschicht auch eine Dielektrikumsschicht vorgesehen sein kann.

Entsprechend Ausführungsbeispielen können die Eigenschaften der Antenne mit unterschiedlichen Maßnahmen verbessert werden. Beispielsweise ist entsprechend einem Ausführungsbeispiel eine Perforation im Bereich der Antenne denkbar. Ebenfalls könnte die Chipschicht, wie z. B. der sogenannte Fan-Out-Bereich im Bereich der Antenne mittels Perforationsstrukturen versehen sein. Eine weitere Maßnahme wäre es, im Bereich der Antenne in der Chipebene einen Spacer mit oder ohne zusätzlichen Reflektor vorzusehen. All diese Maßnahmen ermöglichen ein Filtern bzw. allgemeiner ein Einstellen der zu emittierenden Strahlung.

Entsprechend einem weiteren Ausführungsbeispiel wird ein Verfahren geschaffen, entsprechend welchem das oben genannte Wafer Level Package herstellbar ist. Hierbei wird in einem ersten Schritt die Chipschicht zusammen mit der Kontaktierungsschicht hergestellt. In einem nächsten Schritt wird dann auf einer gegenüberliegenden Schicht zu der Kontaktierungsschicht die Umverdrahtungsschicht aufgebracht, wobei diese Umverdrahtungsschicht eben zumindest die Antenne umfasst.

Ein Ausführungsbeispiel eines weiteren Aspekts der Erfindung schafft ein Wafer Level Package mit einem integrierten Antennenelement. Hierbei umfasst das Wafer Level Package eine Kontaktierungsschicht, eine Umverdrahtungsschicht sowie eine dazwischen angeordnete Chipschicht, wobei in einem Bereich der Chipschicht heben einem der Chips ein integriertes Antennenelement vorgesehen ist. Dieses integrierte Antennenelement kann entsprechend weiteren Ausführungsbeispielen über die Umverdrahtungsschicht elektrisch kontaktiert werden. Die integrierte Antenne ist lateral so in der Umverdrahtungsschicht angeordnet ist, dass eine Projektionsfläche der integrierten Antenne versetzt oder maximal partiell überlappend mit einer Projektionsfläche des zumindest einen Chips ist.

Der Kerngedanke dieses Aspekts ist es, dass die seitliche Anordnung des Antennenelements auch neben dem Chip direkt in der Chipschicht erfolgen kann. Ein derartiges Wafer Level Package ist sehr einfach und kostengünstig herzustellen, wobei allgemein beim Design des Wafer Level Package nicht darauf Rücksicht genommen werden muss, wie die weiteren externen Elemente angeordnet sind, da bevorzugterweise die Antenne seitliche angeordnet ist, sodass diese seitlich und/oder durch die Umverdrahtungsschicht (hindurch) abstrahlt.

Erfindungsgemäß umfasst das Wafer Level Package des zweiten Aspekts ebenfalls ein Schirm-Via zwischen dem Antennenelement und den Chips a, um gegenseitige elektromagnetische Beeinflussung zu reduzieren.

Entsprechend weiteren Ausführungsbeispielen umfasst die Chipschicht ein Polymermaterial, das sowohl die Chips als auch die eine oder mehreren Antennenelemente einbettet. Hierbei sei angemerkt, dass entsprechend bevorzugten Ausführungsbeispielen das Antennenelement als Einzelkomponente ausgeführt ist.

Ein weiteres Ausführungsbeispiel schafft ein Herstellungsverfahren dieses Wafer Level Package. Hierbei werden die Chips und Antennenelemente bereitgestellt und in einem nächsten Schritt zu einer Chipschicht verbunden. Danach wird auf die eine Seite die Kontaktierungsschicht und auf die andere Seite die Umverdrahtungsschicht auf die Chipschicht aufgebracht.

Weiterbildungen sind in den Unteransprüchen definiert. Ausführungsbeispiele der vorliegenden Erfindung werden anhand der beiliegenden Zeichnungen erläutert. Es zeigen:
- Fig. 1: eine schematische Darstellung eines Wafer Level Package mit integrierter Antenne gemäß einem Basisausführungsbeispiel;
- Fig. 2a-2d: schematische Schnittdarstellungen von Wafer Level Package gemäß erweiterten Ausführungsbeispielen;
- Fig. 2e: eine schematische Schnittdarstellung eines Wafer Level Package mit Linse gemäß einem Ausführungsbeispiel;
- Fig. 2f: eine schematische Schnittdarstellung eines Wafer Level Package mit Gehäuse gemäß einem Ausführungsbeispiel; und
- Fig. 3: eine schematische Schnittdarstellung eines Wafer Level Package mit integriertem Antennenelement
- Fig. 4: eine schematische Schnittdarstellung von einem Wafer Level Package mit integrierter Antenne oder Antennenelement in Kombination mit einem weiteren Wafer Level Package gemäß einem weiteren Ausführungsbeispiel; und
- Fig. 5a-5b: schematische Darstellungen von Stand-der-Technik-Ansätzen von Wafer Level Packages.

Bevor nachfolgend Ausführungsbeispiele der vorliegenden Erfindung anhand der beiliegenden Zeichnungen im Detail erläutert werden, sei darauf hingewiesen, dass gleichwirkende Elemente und Strukturen mit gleichen Bezugszeichen versehen sind, sodass die Beschreibung derer austauschbar ist.

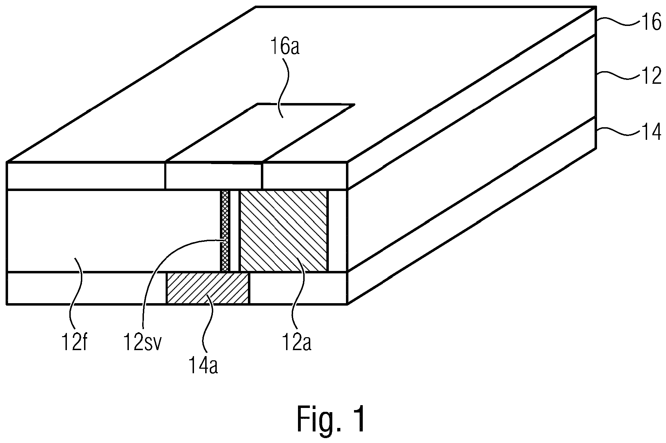

Fig. 1 zeigt ein Wafer Level Packages 10 (Anordnung von Waferebenen zu einer Einheit) mit einer Chipschicht 12 sowie eine auf der Unterseite bzw. ersten Seite angeordneten Kontaktierungsschicht 14 und eine auf der Oberseite bzw. zweiten Seite angeordneten Umverdrahtungsschicht 16. Unter Vernachlässigung von optional vorhandenen Isolationsschichten heißt es also, dass hier die Chipschicht 12 beidseitig metallisiert ist.

Die Chipschicht 12 umfasst zumindest einen Chip 12a, wie z. B. einen RF-Chip. Dieser Chip 12a ist in die Chipschicht 12, z. B. unter Zuhilfenahme von einem Polymer oder einem anderen Moldmaterial eingebettet. Dieser "Einbettungsbereich" wird auch als Fan-Out-Bereich bezeichnet und ist mit dem Bezugszeichen 12f versehen. Der Fan-Out Bereich ist eigentlich der Bereich rechts oder links vom eingebettete Chip 12a, wo andere Komponenten wie z.B. Kapazitäten oder widerstände eingebettete werden können.

Die Schicht 16 ist die Zwischenkontaktierungsschicht, in welcher auch die eine oder mehreren Antennen 16a angeordnet sind. Entsprechend bevorzugten Ausführungsbeispielen ist in Bezug auf die Projektion ein Versatz zwischen den Antennen 16a und den Chips 12a vorgesehen, wie auch hier dargestellt. In anderen Worten heißt es, dass die eine oder mehreren Antennen 16a in dem Fan-Out-Bereich 12f angeordnet sind. Je nach genauer Anordnung kann der Chip 12a mit der Antenne 16a entweder direkt verbunden sein (im Fall des minimalen Überlapps) oder, was (aus EMV-Sicht) die bevorzugte Variante ist, seitlich vom Chip im Fan-Out Bereich angeordnet sein und verbunden über eine Leitung (nicht dargestellt) in der Umverdrahtungsschicht 16.

Im Allgemeinen wird der Chip 12a zum einen in die Umverdrahtungsschicht 16 und optional zusätzlich auch über die Kontaktierungsschicht 14 kontaktiert. Die Kontaktierung des gesamten Wafer Level Package 10 erfolgt über die Kontaktierungsschicht 14, in welcher auch der Reflektor 14a gegenüber der Antenne 16a angeordnet ist. Hierzu kann entsprechend weiteren Ausführungsbeispielen die Kontaktierungsschicht 14 über Vias, die sich durch das Moldmaterial 12f erstrecken, verbunden sein (TMV). Zumindest ein weiteres Vias 12sv zur Schirmung ist im Bereich zwischen Chip 12a und Antenne 16a, also z.B. im sog. Fan-Out Bereich vorgesehen.

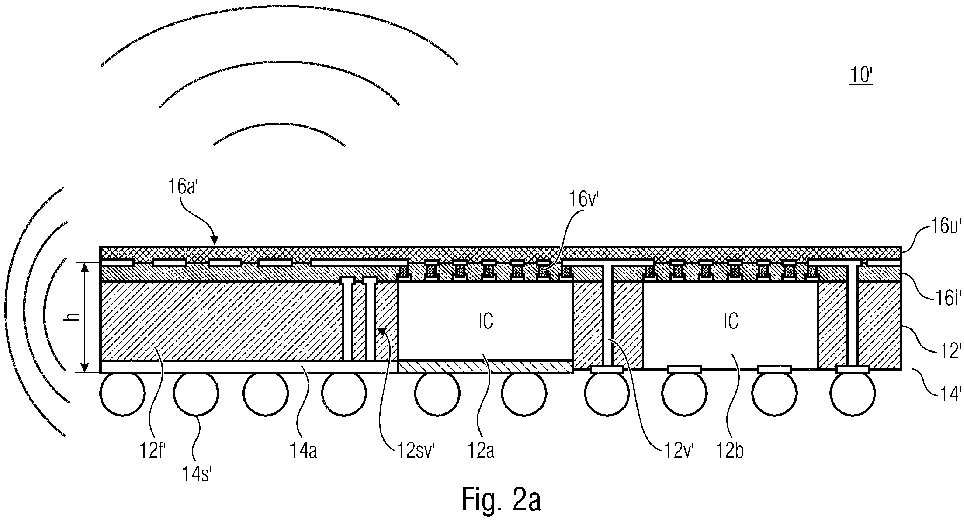

Bezug nehmend auf die Fig. 2a-d werden erweiterte Ausführungsbeispiele gezeigt. Fig. 2a zeigt ein Wafer Level Package 10' mit einer Chipschicht 12', einer Kontaktierungsschicht 14' und einer Umverdrahtungsschicht 16'. Auch hier ist die Antenne 16a, 16a' vom Chip 12a mittels Schirm-Via(s) 12sv' geschirmt, gegenüber dem Chip 12a versetzt und mit einem Reflektor 14a versehen, um optimale Sendeigenschaften bei geringer Beeinflussung des Chips 12a, 12b sicherzustellen, wie nachfolgend im Detail erläutert wird.

In der Chipschicht 12' sind die zwei Chips 12a und 12b vorgesehen, die auf der Unterseite über die Kontaktierungsschichten 14' kontaktierbar sind. Die Kontaktierungsschicht 14' umfasst zum einen Lötkugeln bzw. Solderballs 14s' als Beispiel, die insbesondere im Bereich der Chips 12a und 12b als sogenannte thermale Kugeln zur Abfuhr von den Temperaturen aus dem IC 12a und 12b ausgeführt sind.

Die Umverdrahtungsschicht 16' umfasst in diesem Ausführungsbeispiel tatsächlich zwei Verdrahtungsschichten, nämlich die eigentliche Umverdrahtungsschicht 16u' und die Isolationsschicht 16i'. Diese Isolationsschicht 16i' ist zwischen der eigentlichen Umverdrahtungsschicht 16u' und der Chipschicht 12' angeordnet. Durch die Isolationsschicht 16i' ragen Kontaktvias 16v', mittels welchen die ICs 12a und 12b mit der Umverdrahtungsschicht 16u' sowie der Antenne 16a, 16a' verbunden sind. Diese Vias sind in die Isolationsschicht 16i' eingebettet. Ebenfalls umfasst die Umverdrahtungsschicht 16u' die Antenne 16a, 16a'. Diese ist hier in dem Fan-Out-Bereich 12f' angeordnet. Infolge dieser Anordnung ergibt sich ein sehr kurzer Signalweg mit wenig Diskontinuitäten, was die Signalintegrität insbesondere für Millimeterwellen und/oder Terahertzsignale verbessert. Alternativ kann die Umverdrahtungslage aus einer Metallisierungslage und zwei dielektrische Lagen bestehn. Die Metallisierungslage wird benutzt um die Chip und Antennen zu verbinden. Die strahlende Elemente der Antennen werden auch in der Metallisierungslage realisiert.

In Abhängigkeit von der Antennenkonfiguration kann die Abstrahlung der Antenne 16a, 16a' aus der Schicht (Bodenebene) oder aus der Seitenschicht (Azimutebene) oder aus beiden Ebenen (wie hier dargestellt) erfolgen. Die Antennenkonfiguration ist beispielsweise über die verwendeten Materialien im Fan-Out-Bereich 12f', in demselben Bereich der Isolationsschicht 16i' und über die Höhe (vgl. Bezugszeichen h) sowie den Reflektor 14a einstellbar. An dieser Stelle sei auch angemerkt, dass unterschiedliche Antennen (sowohl einzelnen Elemente als auch Arrays/Gruppenstrahler mit mehrere Elemente) einsetzbar sind, wie z. B. Patchantenne, Grid-Array, Schlitzantenne, substratintegrierte Wellenleiter (SIW)-basierte Antenne, Dipol, Monopol, usw.

Entsprechend weiteren Ausführungsbeispielen kann hier dargestellt die Umverdrahtungsschicht 16u' mittels Vias 12v' mit der Kontaktierungsschicht 14' verbunden sein. Diese Vias ragen durch die Chipschicht 12' hindurch.

Entsprechend der bevorzugten Variante sind zusätzliche Vias bzw. mehrere Reihen von Vias als sogenannte Schirmvias 12sv' vorgesehen, die bevorzugt zwischen der Antenne 16a, 16a' und den Chips 12a und 12b derart angeordnet sind, dass sie eine Abschirmung der Strahlung, ausgesendet durch die Antenne 16a, 16a' bzw. allgemein aller relevanten EMV-Beeinflussungen zwischen IC 12a/12b und Antenne 16a, 16a' vornehmen. Hierdurch werden weitestgehend EMV-Probleme dadurch sowohl eine Beeinflussung der Antenne 16a, 16a' durch die Chips 12a und 12b als auch umgekehrt vermieden. Die Schirmvias 12sv' sind nicht mit dem Chip 12a / 12b und/oder Reflektor 14a (elektrisch) verbunden.

Entsprechend weiteren Ausführungsbeispielen können sowohl in der Umverdrahtungsschicht 16u' als auch in dem Fan-Out-Bereich 12f' passive Bauelemente, wie z. B. Induktivitäten, Widerstände, Kondensatoren, Filter oder andere Elemente vorgesehen sein. Für den Fall, dass diese Elemente in der Chipschicht 12' angeordnet sind, kann eine Kontaktierung über die Umverdrahtungsschicht 16' erfolgen.

Bezüglich der oben bereits erläuterten Lotkugeln 14s sei angemerkt, dass für diese im Regelfall das Wafer Level Package (EWLB) auf einer Leitschicht (z. B. PCB) aufgebbracht wird, so dass über die Lotkugeln 14s' auch der Signalaustausch erfolgt.

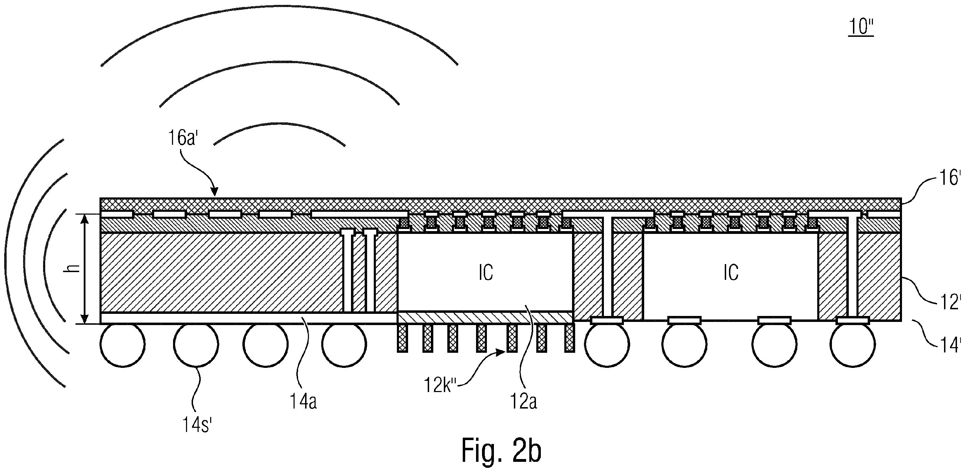

Fig. 2b zeigt ein verändertes Wafer Level Package 10", das gegenüber dem Wafer Level Package 10' insofern verändert ist, dass im Bereich des ICs 12a statt der Lotkugeln 14s' nun weitere Mittel zum Kühlen 12k", nämlich ein Kühlkörper 12k" vorgesehen sind. Der Kühlkörper 12k" spreizt die Wärme in die Umgebung unter dem Chip 12a und die Lotkugeln 14s' leiten die Wärme in das nächste Package Level, z. B. das Systemboard.

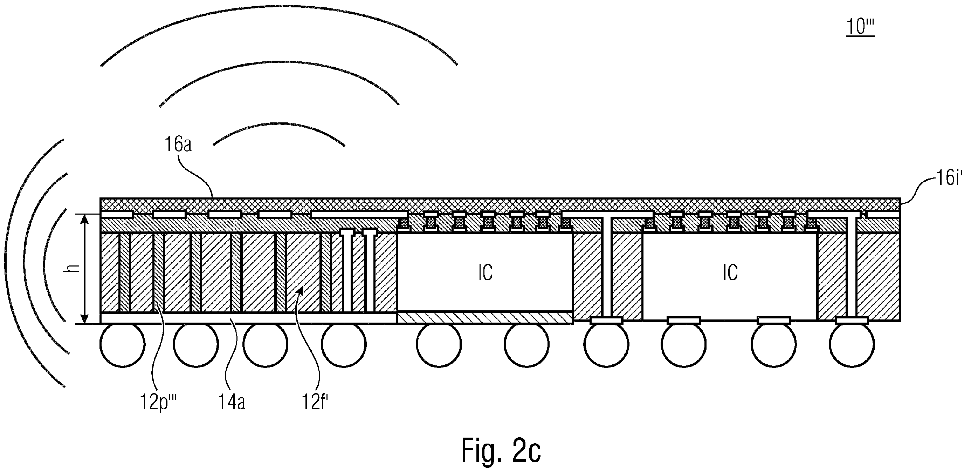

Fig. 2c zeigt ein weiteres Ausführungsbeispiel eines Wafer Level Package 10"', das sich von dem Wafer Level Package 10' dadurch unterscheidet, dass in dem Fan-Out-Bereich 12f' nun Perforationsstrukturen 12p'" vorgesehen sind. Dieser Fan-Out-Bereich 12f' wirkt als Dielektrikum für die Antenne 16a und umfasst deshalb ein geeignetes HF-Material. An dieser Stelle sein angemerkt, dass das Dielektrikum, das benutzt wird, um die Chip einzubetten, auch als Dielektrikum der Antennen dient.

Bei diesen Ausführungsbeispielen ermöglichen die periodischen Löcher 12p'" das Ausbilden einer photonischen Bandgap-Struktur, die zur Filterung der Oberflächenwellen und damit zur Verbesserung der Abstrahlcharakteristik führt. Weiterhin sinkt der Wert der effektiven Primitivität des Substrats durch diese Löcher 12p"'. Dadurch erhöht sich die Kantenlänge der Antennenstruktur bei höheren Frequenzen und der Einfluss der Prozessschwankungen wird geringer. Die Abstrahlcharakteristik der Antenne 16a kann durch Integration von elektromagnetischen Bandgap-Chips auch in die Isolationsschicht 16i' verbessert werden.

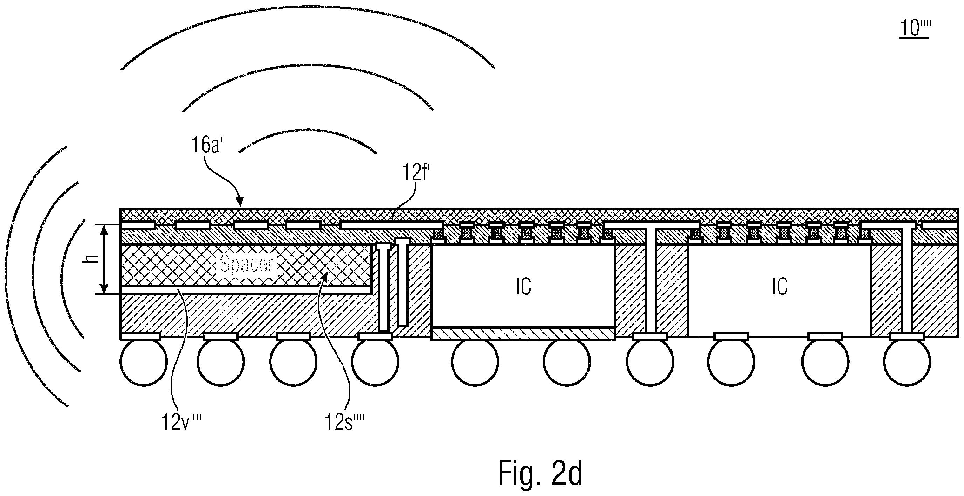

Fig. 2d zeigt eine anders geartete Optimierung des Fan-Out-Bereichs 12f' des Wafer Level Package 10"" im Bereich der Antenne 16a'. Wie hier zu erkennen ist, ist in dem Fan-Out-Bereich 12f' ein sogenannter Spacer 12s"" vorgesehen. Dieser Spacer 12s'" ermöglicht die Einstellung der Höhe h und damit der Dicke des Antennensubstrats. Am Ende des Spacers, d. h. an der von der Antenne 16a' gesehen, gegenüberliegenden Seite des Spacers 12s"" kann ein Reflektor 12v"", z. B. aus Metall vorgesehen sein. Dazwischen befindet sich im Regelfall ein dielektrisches Material des Spacers 12s"", das insbesondere bei dem Design der Antenne 16a' berücksichtigt werden muss.

An dieser Stelle sei angemerkt, dass die Einzelmerkmale, wie sie in Fig. 2a bis 2d erläutert wurden, beliebig kombinierbar sind.

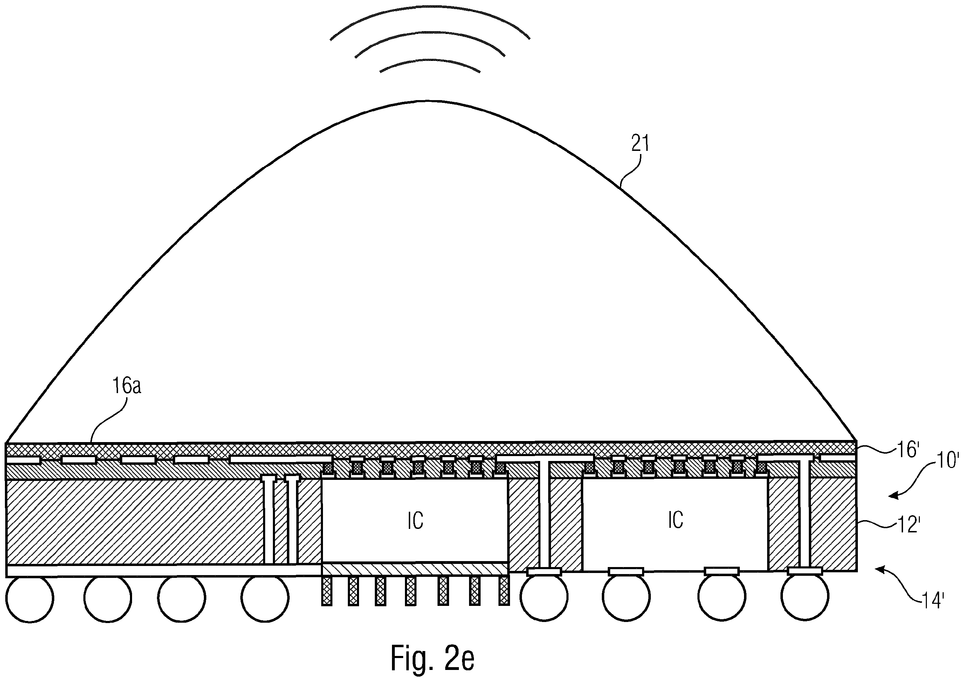

Fig. 2e zeigt das Wafer Level Package 10' aus Fig. 2a mit Chipschicht 12', Kontaktierungsschicht 14' und Umverdrahtungsschicht 16'. In diesem Ausführungsbeispiel weist das Wafer Level Package 10' eine zusätzliche Linse 21 (Mittel zur Strahlformung der elektromagnetischen Welle ausgesendet durch die Antenne) auf der Oberseite (Hauptoberfläche), benachbart zur Antenne 16a'. Die Linse 21 dient zur vertikale Fokussierung des Antennenstrahls.

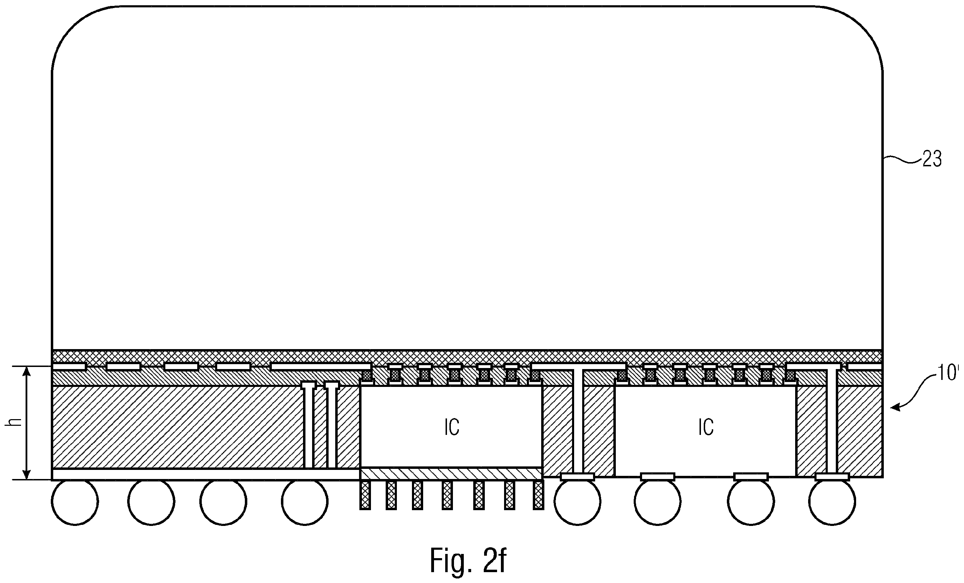

Fig. 2f zeigt wiederum das Wafer Level Package 10' aus Fig. 2a in Kombination mit einem auf der Oberseite (Seite der Umverdrahtungsschicht 16') angeordneten Gehäuse 23. Das Gehäuse 23 ist bevorzugt aus Glas oder einem anderen nicht schirmenden Material. Das Gehäuse 23 kann z.B. mit Luft oder einem dielektrischen Material mit geringen Verlusten gefüllt sein. Ferner kann das Gehäuse 23 auch zur Strahlformung / Fokussierung der elektromagnetischen Welle beitragen.

Sowohl Gehäuse 23 als auch Linse 21 sind zusammen und in Kombination mit allen oben erläuterten Ausführungsbeispielen / Wafer Level Packages anwendbar.

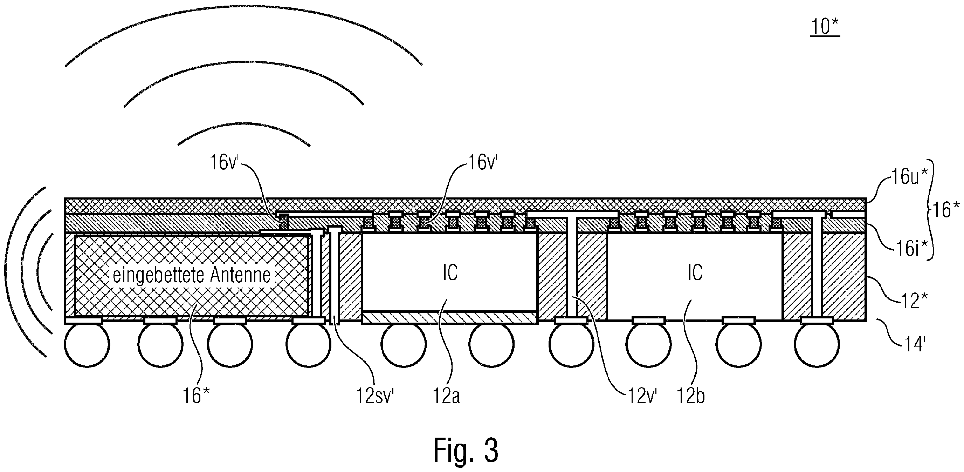

Fig. 3 zeigt ein Wafer Level Package 10*, das im Wesentlichen dem Wafer Level Package 10' entspricht, wobei allerdings hier die Antenne nicht in der Umverdrahtungsschicht 16* umfassend die eigentliche Umverdrahtungsschicht 16u* und die Isolationsschicht 16i*, angeordnet ist, sondern in der Chipschicht 12*.

Die Chipschicht 12* umfasst jedenfalls die zwei ICs 12a und 12b, wobei in dem vorher als Fan-Out-Bereich bezeichneten Bereich nun ein eingebettetes Antenne 16* vorgesehen ist. An dieser Stelle sei auch angemerkt, dass unterschiedliche Antennen (sowohl einzelnen Elemente als auch Arrays/Gruppenstrahler mit mehrere Elemente) einsetzbar sind, wie z. B. Patchantenne, Grid-Array, Schlitzantenne, substratintegrierte Wellenleiter (SIW)-basierte Antenne, Dipol, Monopol, usw. Bei diesem Antenne 16* kann es sich beispielsweise auch um eine hybride Antenne handeln. Entsprechend Ausführungsbeispielen erfolgt die Kontaktierung der Antenne 16* mittels der Umverdrahtungsschicht 16u*, d. h. also, dass der Chip 12a/12b, (RF- bzw. HF-Chip) unter Zuhilfenahme der Umverdrahtungsschicht 16u* mit dem Antenne* verbunden ist. Wie bereits im Zusammenhang mit Fig. 2a erläutert, erfolgt die Kontaktierung des Antennenelements 16* sowie der Chips 12a und 12b durch die Isolationsschicht 16i* über Vias 16v'. Der Vollständigkeit halber sei darauf hingewiesen, dass das hier erläuterte Ausführungsbeispiel 10* ebenso eine Kontaktierungsschicht 14' umfasst.

Entsprechend Ausführungsbeispielen kann, wie beispielsweise im Zusammenhang mit Fig. 2a erläutert, zwischen dem Antenne 16* und dem Chip 12a ein Schirm-Via 12sv' bzw. eine Reihe von Schirm-Vias 12sv' vorgesehen sein.

Entsprechend weiteren Ausführungsbeispielen wirkt im Bereich der Antenne die Isolationsschicht 16i* als Teil des Dielektrikums der Antenne.

Die Funktionalität des Wafer Level Package 10* mit dem integrierten Antenne 16* entspricht im Wesentlichen den Antenne, die bereits oben erläutert wurden. Der Vorteil dieser Konfiguration ist, dass hier das Antenne 16* vollkommen unabhängig hergestellt und getestet werden kann, da das Antenne 16* ebenso wie ein Chip in die Chipschicht 12* eingebettet wird. Weiter ist hier auch vorteilhaft, dass das Design, die Dimensionierung und Optimierung des Antenne 16* unabhängig von den weiteren Elementen erfolgen kann.

Die Merkmale (Perforation der Isolationsschichten oder Spacer), wie sie in Fig. 2a bis 2d erläutert wurden, können ebenfalls zum Einsatz kommen.

Gemäß einem weiteren Ausführungsbeispiel wird ein System geschaffen, bei dem das Wafer Level Package mit (zumindest) einem weiteren (andersartigem oder gleichem) Wafer Level Package verbunden ist. Die Vebindung erfolgt z.B. über die Kontaktierungsschicht. Das weitere Wafer Level Package kann z.B. ebenfalls ein oder mehrerer Antennen (Array) umfassen, sodass im Ergebnis eine dreidimensionale Antennenstruktur geschaffen wird.

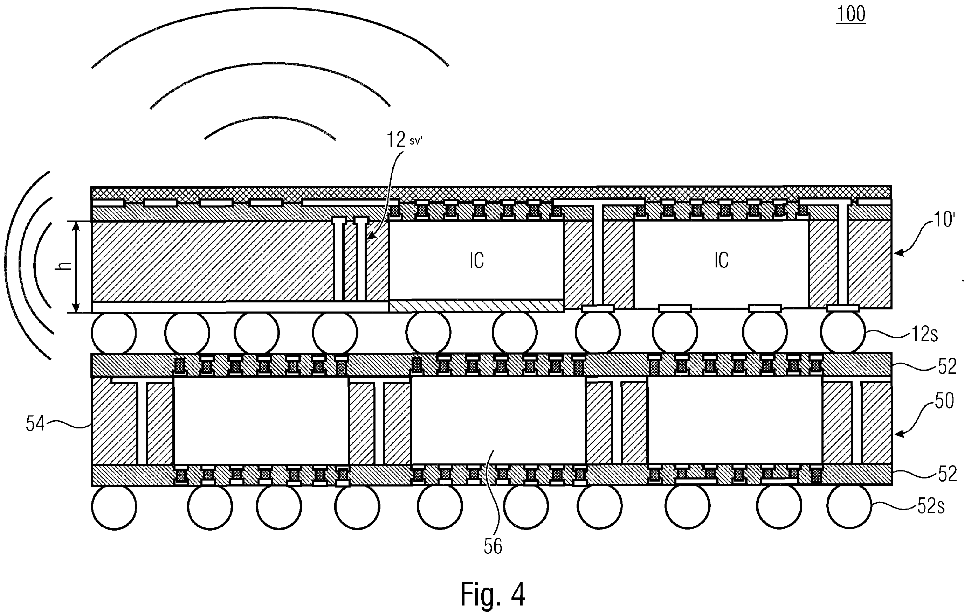

Fig. 4 zeigt ein weiteres Ausführungsbeispiel, nämlich im Wesentlichen die Integration eines der oben erläuterten Wafer Level Packages 10, 10', 10", 10"', 10"" oder 10* in einer Wafer Level Package-Anordnung 100. Hier ist exemplarisch das Wafer Level Package 10' in Kombination mit einem weiteren Wafer Level Package 50 dargestellt, wobei auch die anderen Wafer Level Packages 10, 10", 10'", 10"" oder 10* ebenso kombinierbar wäre.

Die beiden Wafer Level Packages 10' und 50 sind unter Zuhilfenahme der Lotkugeln 12s miteinander verbunden, wobei hier das Wafer Level Package 50 sowohl auf der Oberseite als auch auf der Unterseite eine Kontaktierungsschicht 52 hat. Zwischen diesen zwei Kontaktierungsschichten 52 ist eine Chipschicht 54 vorgesehen, die in diesem Ausführungsbeispiel zumindest drei Elemente 650 hat, die beispielsweise Chips oder andere Bauelemente sein können. Analog zu dem Wafer Level Package 10 ist die Chipschicht 54 mit den drei Bauelementen 56 unter Zuhilfenahme eines Moldmaterials, wie z. B. eines Polymers miteinander verbunden.

Auf der Unterseite des Wafer Level Package 50 ist die Kontaktierungsschicht 52 ebenfalls mit Lotkugeln 52s ausgestattet, so dass hier die gesamte Einheit 100 mit weiteren Wafer Level Packages oder mit einer Leiterplatte verbunden werden kann.

Diese Ausführungsform bietet zum einen die Möglichkeit, dass diese gesamte Wafer Level Package-Anordnung 100 in die dritte Dimension wächst, so dass auch hier höhere Komplexitäten realisierbar sind.

Auch wenn obige Ausführungsbeispiele insbesondere zusammen mit einer Struktur beschrieben wurden, sei darauf hingewiesen, dass weitere Ausführungsbeispiele sich auf die entsprechenden Herstellungsverfahren beziehen.

Das Herstellungsverfahren zu den Wafer Level Packages 10, 10', 10", 10'" und 10"" umfasst die Schritte des Bereitstellens einer Chipschicht sowie des Aufbringens der Umverdrahtungsschicht 16' bzw. 16 sowie der Kontaktierungsschicht 14' bzw. 14. Hierbei wird die Umverdrahtungsschicht 16 bzw. 16' bzw. 16u' derart aufgebracht, dass die Antenne 16a' ausgebildet wird.

Bei der Herstellung des Wafer Level Package 10' mit eingebetteter Antenne werden bei einem ersten Schritt die Chips 12a und 12b sowie die einzubettende Antenne 16* derart angeordnet, dass diese nebeneinander in einer Schicht, die dann die spätere Chipschicht 12x bildet, angeordnet sind. Die Elemente 16*, 12a und 12b werden dann beispielsweise unter Zuhilfenahme eines Gussharzes oder eines anderen Polymermaterials miteinander verbunden, um dann die Schicht 12* herzustellen. In einem nachfolgenden Schritt werden die Metallisierungsschichten bzw. die Kontaktierungsschicht 14' sowie die Umverdrahtungsschicht 16* umfassend die Isolationsschicht 16i* und die eigentliche Umverdrahtungsschicht 16u* aufgebracht.

Die Anwendungsgebiete sind mannigfaltig. Die Plattform 10, 10', 10", 10"' und 10"" bzw. 10* bzw. das Modul 100 kann eingesetzt werden, um drahtlose Kommunikationssysteme, die in allen Frequenzbereichen des elektromagnetischen Spektrums eingesetzt werden können, zu entwickeln, z. B. für WPAN, WLAN, Mobilfunk, Satelliten, Backhaul, Wireless Infrastructure, usw.

Das kann auch eingesetzt werden, um drahtlose Sensorsysteme, die für beliebige Anwendungen in allen Frequenzbereichen des elektromagnetischen Spektrums eingesetzt werden können, zu entwickeln.

Weiterhin kann die Plattform 10, 10', 10", 10"' und 10"" bzw. 10* bzw. das Modul 100 eingesetzt werden, um Radarsysteme, die für beliebige Anwendungen in allen Frequenzbereichen des elektromagnetischen Spektrums eingesetzt werden können, zu entwickeln.

Wie oben bereits erwähnt, kann die integrierten Antenne als Gruppenstrahler ausgeführt sein oder ein Antennenarray, z.B. mit einer Vielzahl von Antennen (>5 oder sogar >1000) umfassen. Hier sind die mehreren Antennen bevorzugt nebeneinander so angeordnet, dass kein oder nur ein minimaler Überlapp mit weiteren Elementen, wie den Chips entsteht.

An dieser Stelle sei angemerkt, dass obige Ausführungsbeispiele nur illustrativ sind, während der Schutzbereich durch die nachfolgenden Patentansprüche festgelegt wird.

### Referenzen:

[1] T. Meyer, G. Ofner, S. Bradl, M. Brunnbauer, R. Hagen, Embedded Wafer Level Ball Grid Array (eWLB); Proceedings of EPTC 2008, Singapore.
[2] B. Keser, C. Amrine, T. Duong, O. Fay, S. Hayes, G. Leal, W. Lytle, D. Mitchell, R. Wenzel; The Redistributed Chip Package: A Breakthrough for Advanced Packaging, Proceedings of ECTC 2007, Reno/Nevada, USA.
[3] Chung-Hao Tsai et AI., Array Antenna Integrated Fan-out Wafer Level Packaging (InFO-WLP) for Millimeter Wave System Applications", 2013 IEEE International Electronic Devices Meeting (IEDM), 9-11 Dec. 2013, pp. 25.1.1 - 25.1.4.
[4] Christopher Beck, et al., Industrial mmWave Radar Sensor in Embedded Wafer Level BGA Packaging Technology", IEEE SENSORS JOURNAL, VOL. 16, NO. 17, SEPTEMBER 1, 2016

## Patentansprüche

1. Wafer Level Package (10, 10', 10", 10"', 10"") mit integrierter Antenne, mit folgenden Merkmalen:
einer Kontaktierungsschicht (14, 14');
einer Umverdrahtungsschicht (16, 16', 16u') mit der integrierten Antenne;
einer zwischen der Kontaktierungsschicht (14, 14') und der Umverdrahtungsschicht (16, 16', 16u') angeordneten Chipschicht (12, 12') umfassend zumindest einen Chip (12a, 12b);
wobei die integrierte Antenne (16a, 16a') lateral so in der Umverdrahtungsschicht (16, 16', 16u') angeordnet ist, dass eine Projektionsfläche der integrierten Antenne versetzt oder teilweise überlappend mit einer Projektionsfläche des zumindest einen Chips (12a, 12b) ist, wobei der Chip (12a, 12b) unter Zuhilfenahme der Umverdrahtungsschicht (16, 16', 16u') mit der integrierten Antenne (16a, 16a') verbunden ist;
wobei die Kontaktierungsschicht (14, 14') einen Reflektor (14a) ge-genüber der Antenne (16a, 16a'), für die Antenne (16a, 16a') umfasst oder ein Reflektor (12v"") gegenüber der Antenne (16a, 16a') auf einer der Antenne abgewandten Seite angeordnet ist, um so mit selbiger wechselzuwirken; und
wobei zumindest ein Schirm-Via (12sv') neben dem Chip (12a, 12b) und angeordnet ist, wobei das zumindest eine Schirm-Via (12sv') ausgebildet ist, um eine Schirmung zwischen der integrierten Antenne und dem mindestens einen Chip (12a, 12b) herzustellen und wobei keine elektrische Verbindung zwischen dem zumindest einem Schirm-Via (12sv') und dem Chip (12a, 12b) sowie dem Reflektor (14a, 12v"") besteht.

2. Wafer Level Package (10, 10', 10", 10'", 10"") gemäß Anspruch 1, wobei die integrierte Antenne als Gruppenstrahler ausgeführt ist oder ein Antennenarray umfasst.

3. Wafer Level Package (10, 10', 10", 10"', 10"") gemäß Anspruch 1 oder 2, wobei die Chipschicht (12, 12') Polymermaterial hat, das neben dem mindestens einen Chip (12a, 12b) angeordnet ist.

4. Wafer Level Package (10, 10', 10", 10'", 10"") gemäß Anspruch 3, wobei zumindest ein Via (12v') durch das Polymermaterial durchragt, so dass die Umverdrahtungsschicht (16, 16', 16u') kontaktiert wird.

5. Wafer Level Package (10, 10', 10"(12, 12') gemäß einem der vorherigen Ansprüche, wobei das zumindest ein Schirm-Via (12sv') als Reihe von Schirm-Vias (12sv') gebildet ist.

6. Wafer Level Package (10, 10', 10", 10"', 10"") gemäß einem der vorherigen Ansprüche, wobei der Chip (12a, 12b) beidseitig kontaktiert ist.

7. Wafer Level Package (10, 10', 10", 10"', 10"") gemäß einem der vorherigen Ansprüche, wobei ein Dielektrikum (16i') zwischen der Chipschicht (12, 12') und der Umverdrahtungsschicht (16, 16', 16u') angeordnet ist.

8. Wafer Level Package (10, 10', 10", 10"', 10"") gemäß Anspruch 7, wobei das Dielektrikum (16i') zumindest in einem Teil des Bereichs der integrierten Antenne perforiert ist.

9. Wafer Level Package (10, 10', 10", 10"', 10"") gemäß Anspruch 3 oder 4, wobei das Polymermaterial im Bereich der integrierten Antenne zumindest eine Perforationsstruktur (12p"') umfasst.

10. Wafer Level Package (10, 10', 10", 10"', 10"") gemäß einem der Ansprüche 3, 4 oder 9, wobei das Polymermaterial zumindest in einem Teil des Bereichs der Antenne einen Spacer (12s"") umfasst.

11. Wafer Level Package (10, 10', 10", 10'", 10"") gemäß einem der vorherigen Ansprüche, wobei der Reflektor (14a') überlappend mit der Projektionsfläche der integrierten Antenne angeordnet ist.

12. Verfahren zur Herstellung eines Wafer Level Package (10, 10', 10", 10'", 10"") mit einer integrierten Antenne, mit folgenden Schritten:
Bereitstellen einer Chipschicht (12, 12'), umfassend zumindest einen Chip (12a, 12b);
Aufbringen einer Kontaktierungsschicht (14, 14') auf die Chipschicht (12, 12'); und
Aufbringen einer Umverdrahtungsschicht (16, 16', 16u') auf die Chipschicht (12, 12') in derart, dass die Umverdrahtungsschicht (16, 16', 16u') gegenüberliegend zu der Kontaktierungsschicht (14, 14') angeordnet ist, wobei die Umverdrahtungsschicht (16, 16', 16u') zumindest die Antenne umfasst;
wobei die integrierte Antenne (16a, 16a') lateral so in der Umverdrahtungsschicht (16, 16', 16u') angeordnet ist, dass eine Projektionsfläche der integrierten Antenne versetzt oder teilweise überlappend mit einer Projektionsfläche des zumindest einen Chips (12a, 12b) ist, wobei der Chip (12a, 12b) unter Zuhilfenahme der Umverdrahtungsschicht (16, 16', 16u') mit der integrierten Antenne (16a, 16a') verbunden ist;;
wobei die Kontaktierungsschicht (14, 14') einen Reflektor (14a) gegenüber der Antenne (16a, 16a'), für die Antenne (16a, 16a') umfasst oder ein Reflektor (12v"") gegenüber der Antenne (16a, 16a') auf einer der Antenne abgewandten Seite angeordnet ist, um so mit selbiger wechselzuwirken; und
wobei zumindest ein Schirm-Via (12sv') neben dem Chip (12a, 12b) und angeordnet ist, wobei das zumindest eine Schirm-Via (12sv') ausgebildet ist, um eine Schirmung zwischen der integrierten Antenne und dem mindestens einen Chip (12a, 12b) bereitzustellen und wobei keine elektrische Verbindung zwischen dem zumindest einem Schirm-Via (12sv') und dem Chip (12a, 12b) sowie dem Reflektor (14a, 12v"") besteht.

13. Verfahren gemäß Anspruch 12, das den Schritt des Einbringens von ein oder mehrerer Vias (12v') durch ein Polymermaterial der Chipschicht (12, 12') aufweist, so dass die Umverdrahtungsschicht (16, 16', 16u') kontaktiert wird.

14. Wafer Level Package (10*) mit integrierter Antenne, mit folgenden Merkmalen:
einer Kontaktierungsschicht (14, 14');
einer Umverdrahtungsschicht (16, 16', 16u'); und
einer zwischen der Kontaktierungsschicht (14, 14') und der Umverdrahtungsschicht (16, 16', 16u') angeordneten Chipschicht (12, 12'), umfassend zumindest einen Chip (12a, 12b) sowie die integrierte Antenne, wobei die Antenne (16*) als Einzelkomponente ausgeführt ist, wobei der Chip (12a, 12b) unter Zuhilfenahme der Umverdrahtungsschicht (16, 16', 16u') mit der integrierten Antenne (16a, 16a') verbunden ist;
wobei die Kontaktierungsschicht (14, 14') einen Reflektor (14a) für die Antenne (16a, 16a') umfasst oder ein Reflektor (12v"") auf einer der Antenne abgewandten Seite angeordnet ist, um so mit selbiger wechselzuwirken;
wobei zwischen dem zumindest einen Chip (12a, 12b) und der Antenne (16*) ein Schirmvia (12sv') angeordnet ist, das ausgebildet ist, um Chip (12a, 12b) und die Antenne (16*) voneinander abzuschirmen, und wobei keine elektrische Verbindung zwischen dem zumindest einem Schirm-Via (12sv') und dem Chip (12a, 12b) sowie dem Reflektor (14a, 12v"") besteht.

15. Wafer Level Package (10*) gemäß Anspruch 14, wobei die integrierte Antenne (16*) über die Umverdrahtungsschicht (16u*, 16*) mit der Chipschicht (12*) elektrisch verbunden ist.

16. Wafer Level Package (10*) gemäß einem der Ansprüche 14 bis 15, wobei die Chipschichten (12*) ein Polymermaterial umfasst.

17. Wafer Level Package (10*) gemäß Anspruch 16, wobei die Umverdrahtungsschicht (16u*, 16*) mittels eines Vias (12v') mit der Kontaktierungsschicht (14') verbunden ist.

18. Wafer Level Package (10, 10', 10", 10'", 10"", 10*) gemäß einem der Ansprüche 1 bis 11 und 14 bis 17, wobei der mindestens eine Chip (12a, 12b') auf einer der Umverdrahtungsschicht (16, 16', 16u') abgewandten Seite Mittel zur Temperaturabfuhr (12k") aufweist.

19. Wafer Level Package (10, 10', 10", 10'", 10"", 10*) gemäß einem der Ansprüche 1 bis 11 und 14 bis 17, wobei das Wafer Level Package (10, 10', 10", 10"', 10"", 10*) eine Linse (19) umfasst, die ausgebildet ist, mit zumindest einer integrierten Antenne zusammenzuwirken.

20. Verfahren zur Herstellung eines Wafer Level Package (10*) mit integrierter Antenne (16*), mit folgenden Schritten:
Bereitstellen von zumindest einem Chip (12a, 12b) und zumindest einem Antennenelement (16*) wobei die Antenne (16*) als Einzelkomponente ausgeführt ist;
Verbinden des zumindest einem Chips (12a, 12b) und des zumindest einem Antennenelements (16*) zu einer Chipschicht (12*);
Aufbringen auf die Chipschicht (12*) einer Kontaktierungsschicht (14');
Aufbringen auf die Chipschicht (12*) einer Umverdrahtungsschicht (16u*, 16*) derart, dass die Umverdrahtungsschicht (16u*, 16*) gegenüberliegend zu der Kontaktierungsschicht (14') angeordnet ist, wobei der Chip (12a, 12b) unter Zuhilfenahme der Umverdrahtungsschicht (16, 16', 16u') mit der integrierten Antenne (16a, 16a') verbunden ist; wobei die Kontaktierungsschicht (14, 14') einen Reflektor (14a) für die Antenne (16a, 16a') umfasst oder ein Reflektor (12v"") auf einer der Antenne abgewandten Seite angeordnet ist, um so mit selbiger wechselzuwirken; und
Anordnen zwischen dem zumindest einen Chip (12a, 12b) und der Antenne (16*) eines Schirmvias (12sv'), das ausgebildet ist, um Chip (12a, 12b) und die Antenne (16*) voneinander abzuschirmen; und wobei keine elektrische Verbindung zwischen dem zumindest einem Schirm-Via (12sv') und dem Chip (12a, 12b) sowie dem Reflektor (14a, 12v"") besteht.

21. Wafer Level Package Anordnung (100) mit einem Wafer Level Package (10, 10', 10", 10"', 10"", 10*) gemäß einem der Ansprüche 1 bis 11 oder 14 bis 19 sowie einem oder mehrere weiteren Wafer Level Package.

## Claims

1. Wafer level package (10, 10', 10", 10"', 10"") with integrated antenna, comprising:
a contacting layer (14, 14');
a rewiring layer (16, 16', 16u') with the integrated antenna;
a chip layer (12, 12') including at least one chip (12a, 12b) arranged between the contacting layer (14, 14') and the rewiring layer (16, 16', 16u');
wherein the integrated antenna (16a, 16a') is laterally arranged in the rewiring layer (16, 16', 16u') such that a projection area of the integrated antenna is offset from or partly overlapping with a projection area of the at least one chip (12a, 12b), wherein the chip (12a, 12b) is connected to the integrated antenna (16a, 16a') with the help of the rewiring layer (16, 16", 16u');
wherein the contacting layer (14, 14') includes a reflector (14a) opposite to the antenna (16a, 16a') for the antenna (16a, 16a') or a reflector (12v"") is arranged opposite to the antenna (16a, 16a') on a side facing away from the antenna in order to cooperate with the same; and
wherein at least one shielding via (12sv') is arranged beside the chip (12a, 12b), wherein the at least one shielding via (12sv') is configured to establish shielding between the integrated antenna and the at least one chip (12a, 12b) and wherein no electrical connection exists between the at least one shielding via (12sv') and the chip (12a, 12b) as well as the reflector (14a, 12v"").

2. Wafer level package (10, 10', 10", 10'", 10"") according to claim 1, wherein the integrated antenna is implemented as antenna array or includes an antenna array.

3. Wafer level package (10, 10', 10", 10'", 10"") according to claim 1 or 2, wherein the chip layer (12, 12') includes polymer material that is arranged beside the at least one chip (12a, 12b).

4. Wafer level package (10, 10', 10", 10"', 10"") according to claim 3, wherein at least one via (12v') projects through the polymer material such that the rewiring layer (16, 16', 16u') is contacted.

5. Wafer level package (10, 10', 10"(12, 12') according to one of the preceding claims, wherein the at least one shielding via (12sv') is formed as a series of shielding vias (12sv').

6. Wafer level package (10, 10', 10", 10"', 10"") according to one of the preceding claims, wherein the chip (12a, 12b) is contacted on both sides.

7. Wafer level package (10, 10', 10", 10'", 10"") according to one of the preceding claims, wherein a dielectric (16i') is arranged between the chip layer (12, 12') and the rewiring layer (16, 16', 16u').

8. Wafer level package (10, 10', 10", 10"', 10"") according to claim 7, wherein the dielectric (16i') is perforated at least in part of an area of the integrated antenna.

9. Wafer level package (10, 10', 10", 10'", 10"") according to claim 3 or 4, wherein the polymer material includes at least one perforation structure (12p'") in the area of the integrated antenna.

10. Wafer level package (10, 10', 10", 10"', 10"") according to one of claims 3, 4 or 9, wherein the polymer material includes a spacer (12s"") at least in one part of the area of the antenna.

11. Wafer level package (10, 10', 10", 10"', 10"") according to one of the preceding claims, wherein the reflector (14a') is arranged overlapping with the projection area of the integrated antenna.

12. Method for manufacturing a wafer level package (10, 10', 10", 10"', 10"") with integrated antenna, comprising:
providing a chip layer (12, 12') including at least one chip (12a, 12b);
depositing a contacting layer (14, 14') onto the chip layer (12, 12'); and
depositing a rewiring layer (16, 16', 16u') on the chip layer (12, 12') such that the rewiring layer (16, 16', 16u') is arranged opposite to the contacting layer (14, 14'), wherein the rewiring layer (16, 16', 16u') includes at least the antenna;
wherein the integrated antenna (16a, 16a') is arranged laterally in the rewiring layer (16, 16', 16u') such that a projection area of the integrated antenna is offset from or partly overlapping with the projection area of the at least one chip (12a, 12b), wherein the chip (12a, 12b) is connected to the integrated antenna (16a, 16a') with the help of the rewiring layer (16, 16', 16u');
wherein the contacting layer (14, 14') includes a reflector (14a) opposite to the antenna (16a, 16a') for the antenna (16a, 16a') or a reflector (12v"") is arranged opposite to the antenna (16*) on a side facing away from the antenna in order to cooperate with the same; and
wherein at least one shielding via (12sv') is arranged beside the chip (12a, 12b), wherein the at least one shielding via (12sv') is configured to provide shielding between the integrated antenna and the at least one chip (12a, 12b) and wherein no electrical connection exists between the at least one shielding via (12sv') and the chip (12a, 12b) as well as the reflector (14a, 12v"").

13. Method according to claim 12 comprising the step of introducing one or several vias (12v') through a polymer material of the chip layer (12, 12'), such that the rewiring layer (16, 16', 16u') is contacted.

14. Wafer level package (10*) with integrated antenna, comprising:
a contacting layer (14, 14');
a rewiring layer (16, 16', 16u'); and
a chip layer (12, 12') including at least one chip (12a, 12b) as well as the integrated antenna arranged between the contacting layer (14, 14') and the rewiring layer (16, 16', 16u'), wherein the antenna (16*) is configured as individual component, wherein the chip (12a, 12b) is connected to the integrated antenna (16a, 16a') with the help of the rewiring layer (16, 16', 16u');
wherein the contacting layer (14, 14') includes a reflector (14a) for the antenna (16a, 16a') or a reflector (12v"") is arranged on a side facing away from the antenna in order to cooperate with the same; and
wherein a shielding via (12sv') is arranged between the at least one chip (12a, 12b) and the antenna (16*) that is configured to shield the chip (12a, 12b) and the antenna (16*) from one another, and wherein no electrical connection exists between the at least one shielding via (12sv') and the chip (12a, 12b) as well as the reflector (14a, 12v"").

15. Wafer level package (10*) according to claim 14, wherein the integrated antenna (16*) is electrically connected to the chip layer (12*) via the rewiring layer (16u*, 16*).

16. Wafer level package (10*) according to one of claims 14 to 15, wherein the chip layers (12*) include a polymer material.

17. Wafer level package (10*) according to claim 16, wherein the rewiring layer (16u*, 16*) is connected to the contacting layer (14') by means of a via (12v').

18. Wafer level package (10, 10', 10", 10"', 10"", 10*) according to one of claims 1 to 11 and 14 to 17, wherein the at least one chip (12a, 12b') includes means for temperature dissipation (12k") on a side facing away from the rewiring layer (16, 16', 16u').

19. Wafer level package (10, 10', 10", 10"', 10"", 10*) according to one of claims 1 to 11 and 14 to 17, wherein the wafer level package (10, 10', 10", 10"', 10"", 10*) includes a lens (19) that is configured to cooperate with at least one integrated antenna.

20. Method for manufacturing a wafer level package (10*) with integrated antenna (16*), comprising:
providing at least one chip (12a, 12b) and at least one antenna element (16*), wherein the antenna (16*) is configured as individual component;
connecting the at least one chip (12a, 12b) and the at least one antenna element (16*) to a chip layer (12*);
depositing a contacting layer (14') on the chip layer(12*); and
depositing a rewiring layer (16u*, 16*) on the chip layer (12*) such that the rewiring layer (16u*, 16*) is arranged opposite to the contacting layer (14'), wherein the chip (12a, 12b) is connected to the integrated antenna (16a, 16a') with the help of the rewiring layer (16, 16', 16u');
wherein the contacting layer (14, 14') includes a reflector (14a) for the antenna (16a, 16a') or a reflector (12v"") is arranged on a side facing away from the antenna in order to cooperate with the same; and
arranging a shielding via (12sv') between the at least one chip (12a, 12b) and the antenna (16*) that is configured to shield the chip (12a, 12b) and the antenna (16*) from one another; and wherein no electrical connection exists between the at least one shielding via (12sv') and the chip (12a, 12b) as well as the reflector (14a, 12v"").

21. Wafer level package arrangement (100) with a wafer level package (10, 10', 10", 10'", 10"", 10*) according to one of claims 1 to 11 or 14 to 19 as well as one or several further wafer level packages.

## Revendications

1. Encapsulation au niveau de plaquette (10, 10', 10", 10"', 10"") avec une antenne intégrée, aux caractéristiques suivantes:
une couche de mise en contact (14, 14');
une couche de recâblage (16, 16', 16u') avec l'antenne intégrée;
une couche de puce (12, 12') disposée entre la couche de mise en contact (14, 14') et la couche de recâblage (16, 16', 16u') comportant au moins une puce (12a, 12b);
dans laquelle l'antenne intégrée (16a, 16a') est disposée latéralement dans la couche de recâblage (16, 16', 16u') de sorte qu'une surface de projection de l'antenne intégrée soit décalée par rapport à ou partiellement en chevauchement avec une surface de projection de l'au moins une puce (12a, 12b), dans laquelle la puce (12a, 12b) est connectée à l'antenne intégrée (16a, 16a') à l'aide de la couche de recâblage (16, 16', 16u');
dans laquelle la couche de mise en contact (14, 14') comporte un réflecteur (14a) face à l'antenne (16a, 16a') pour l'antenne (16a, 16a') ou un réflecteur (12v"") est disposé face à l'antenne (16a, 16a') d'un côté opposé à l'antenne de manière à interagir avec cette dernière; et
dans laquelle au moins un via de blindage (12sv') est disposé à côté de la puce (12a, 12b) et dans laquelle l'au moins un via de blindage (12sv') est conçu pour établir un blindage entre l'antenne intégrée et l'au moins une puce (12a , 12b) et dans laquelle il n'existe pas de connexion électrique entre l'au moins un via de blindage (12sv') et la puce (12a, 12b) ainsi que le réflecteur (14a, 12"").

2. Encapsulation au niveau de plaquette (10, 10', 10", 10"', 10'") selon la revendication 1, dans laquelle l'antenne intégrée est conçue comme un réseau d'antennes ou comporte un réseau d'antennes.

3. Encapsulation au niveau de plaquette (10, 10', 10", 10"', 10"") selon la revendication 1 ou 2, dans laquelle la couche de puce (12, 12') présente un matériau polymère qui est disposé à côté de l'au moins une puce (12a, 12b).

4. Encapsulation au niveau de plaquette (10, 10', 10", 10"', 10"") selon la revendication 3, dans laquelle au moins un via (12v') fait saillie à travers le matériau polymère, de sorte que la couche de recâblage (16, 16', 16u') soit mise en contact.

5. Encapsulation au niveau de plaquette (10, 10', 10" (12, 12') selon l'une des revendications précédentes, dans laquelle l'au moins un via de blindage (12sv') est constitué sous forme d'une série de vias de blindage (12sv').

6. Encapsulation au niveau de plaquette (10, 10', 10", 10"', 10"") selon l'une des revendications précédentes, dans laquelle la puce (12a, 12b) est mise en contact des deux côtés.

7. Encapsulation au niveau de plaquette (10, 10', 10", 10"', 10"") selon l'une des revendications précédentes, dans laquelle un diélectrique (16i') est disposé entre la couche de puce (12, 12') et la couche de recâblage (16, 16', 16u').

8. Encapsulation au niveau de plaquette (10, 10', 10", 10"', 10"") selon la revendication 7, dans laquelle le diélectrique (16i') est perforé au moins dans une partie de la zone de l'antenne intégrée.

9. Encapsulation au niveau de plaquette (10, 10', 10", 10"', 10"") selon la revendication 3 ou 4, dans laquelle le matériau polymère comporte, dans la zone de l'antenne intégrée, au moins une structure de perforation (12p"').

10. Encapsulation au niveau de plaquette (10, 10', 10", 10"', 10"") selon l'une des revendications 3, 4 ou 9, dans laquelle le matériau polymère comporte, au moins dans une partie de la zone de l'antenne, une entretoise (12s"").

11. Encapsulation au niveau de plaquette (10, 10', 10", 10"', 10'") selon l'une des revendications précédentes, dans laquelle le réflecteur (14a') est disposé en chevauchement avec la surface de projection de l'antenne intégrée.

12. Procédé de fabrication d'une encapsulation au niveau de plaquette (10, 10', 10", 10"', 10"") avec une antenne intégrée, aux étapes suivantes consistant à:
mettre à disposition une couche de puce (12, 12') comportant au moins une puce (12a, 12b);
appliquer une couche de mise en contact (14, 14') sur la couche de puce (12, 12'); et
appliquer une couche de recâblage (16, 16', 16u') sur la couche de puce (12, 12') de sorte que la couche de recâblage (16, 16', 16u') soit disposée opposée à la couche de mise en contact (14, 14'), où la couche de recâblage (16, 16', 16u') comporte au moins l'antenne;
dans lequel l'antenne intégrée (16a, 16a') est disposée latéralement dans la couche de recâblage (16, 16', 16u') de sorte qu'une surface de projection de l'antenne intégrée soit décalée par rapport à ou partiellement en chevauchement avec une surface de projection de l'au moins une puce (12a, 12b), dans lequel la puce (12a, 12b) est connectée à l'antenne intégrée (16a, 16a') à l'aide de la couche de recâblage (16, 16', 16u');
dans lequel la couche de mise en contact (14, 14') comporte un réflecteur (14a) face à l'antenne (16a, 16a') pour l'antenne (16a, 16a') ou un réflecteur (12v"") est disposé face à l'antenne (16a, 16a') d'un côté opposé à l'antenne de manière à interagir avec cette dernière; et
dans lequel au moins un via de blindage (12sv') est disposé à côté de la puce (12a, 12b) et dans lequel l'au moins un via de blindage (12sv') est conçu pour établir un blindage entre l'antenne intégrée et l'au moins une puce (12a , 12b) et dans lequel il n'existe pas de connexion électrique entre l'au moins un via de blindage (12sv') et la puce (12a, 12b) ainsi que le réflecteur (14a, 12v"").

13. Procédé selon la revendication 12, qui présente l'étape consistant à introduire un ou plusieurs vias (12v') à travers un matériau polymère de la couche de puce (12, 12'), de sorte que la couche de recâblage (16, 16', 16u') soit mise en contact.

14. Encapsulation au niveau de plaquette (10*) avec une antenne intégrée, aux caractéristiques suivantes:
une couche de mise en contact (14, 14');
une couche de recâblage (16, 16', 16u'); et
une couche de puce (12, 12') disposée entre la couche de mise en contact (14, 14') et la couche de recâblage (16, 16', 16u'), comportant au moins une puce (12a, 12b) ainsi que l'antenne intégrée, où l'antenne (16*) est conçue sous forme de composant individuel, où la puce (12a, 12b) est connectée à l'antenne intégrée (16a, 16a') à l'aide de la couche de recâblage (16, 16', 16u');
dans laquelle la couche de mise en contact (14, 14') comporte un réflecteur (14a) pour l'antenne (16a, 16a') ou un réflecteur (12v"') est disposé d'un côté opposé à l'antenne pour interagir avec cette dernière;
dans laquelle entre l'au moins une puce (12a, 12b) et l'antenne (16*) est disposé un écran via de blindage (12sv') qui est conçu pour blinder la puce (12a, 12b) et l'antenne (16*) l'une de l'autre, et dans laquelle il n'existe pas de connexion électrique entre l'au moins un via de blindage (12sv') et la puce (12a, 12b) ainsi que le réflecteur (14a, 12v"").

15. Encapsulation au niveau de plaquette (10*) selon la revendication 14, dans laquelle l'antenne intégrée (16*) est connectée électriquement à la couche de puce (12*) par l'intermédiaire de la couche de recâblage (16u*, 16*).

16. Encapsulation au niveau de plaquette (10*) selon l'une des revendications 14 à 15, dans laquelle les couches de puce (12*) comportent un matériau polymère.

17. Encapsulation au niveau de plaquette (10*) selon la revendication 16, dans laquelle la couche de recâblage (16u*, 16*) est connectée à la couche de mise en contact (14') au moyen d'un via (12v').

18. Encapsulation au niveau de plaquette (10, 10', 10", 10'", 10"", 10*) selon l'une des revendications 1 à 11 et 14 à 17, dans laquelle l'au moins une puce (12a, 12b') présente, d'un côté opposé à la couche de recâblage (16, 16', 16u'), des moyens de dissipation de température (12k").

19. Encapsulation au niveau de plaquette (10, 10', 10", 10"', 10"", 10*) selon l'une des revendications 1 à 11 et 14 à 17, dans laquelle l'encapsulation au niveau de plaquette (10, 10', 10", 10'", 10"" 10*) comporte une lentille (19) qui est conçue pour interagir avec au moins une antenne intégrée.

20. Procédé de fabrication d'une encapsulation au niveau de plaquette (10*) avec une antenne intégrée (16*), aux étapes suivantes consistant à:
mettre à disposition au moins une puce (12a, 12b) et au moins un élément d'antenne (16*), où l'antenne (16*) est conçue sous forme de composant individuel;
assembler l'au moins une puce (12a, 12b) et l'au moins un élément d'antenne (16*) pour obtenir une couche de puce (12*);
appliquer sur la couche de puce (12*) une couche de mise en contact (14');
appliquer sur la couche de puce (12*) une couche de recâblage (16u*, 16*) de sorte que la couche de recâblage (16u*, 16*) soit disposée opposée à la couche de mise en contact (14'), où la puce (12a, 12b) est connectée à l'antenne intégrée (16a, 16a') à l'aide de la couche de recâblage (16, 16', 16u'); où la couche de mise en contact (14, 14') comporte un réflecteur (14a) pour l'antenne (16a, 16a') ou un réflecteur (12v"") est disposé d'un côté opposé à l'antenne pour interagir avec cette dernière; et
disposer entre l'au moins une puce (12a, 12b) et l'antenne (16*) un via de blindage (12sv') qui est conçu pour blinder la puce (12a, 12b) et l'antenne (16*) l'une de l'autre; et où il n'existe pas de connexion électrique entre l'au moins un via de blindage (12sv') et la puce (12a, 12b) ainsi que le réflecteur (14a, 12v"").

21. Aménagement d'encapsulation au niveau de plaquette (100) avec une encapsulation au niveau de plaquette (10, 10', 10", 10"', 10"" 10*) selon l'une des revendications 1 à 11 ou 14 à 19 ainsi qu'une ou plusieurs autres encapsulations sur plaquette.
